# EUROPEAN PATENT APPLICATION

(11) **EP 4 394 849 A1**
(43) Date of publication of application: **03.07.2024**
(21) Application number: 22883322.4
(22) Date of filing: 30.09.2022
(51) Int. Cl.: H01L 21/368, B05D 3/00, B05D 3/12, B05D 7/24, H01G 9/20, H10K 30/80

(54) **PRODUCTION METHOD FOR TIN-BASED PEROVSKITE LAYER**

(30) Priority: 18.10.2021 JP 2021170558
(71) Applicant: CKD Corporation, Komaki-shi, Aichi 485-8551 (JP); The University of Electro-Communications, Chofu-shi, Tokyo 182-8585 (JP); Ushio Denki Kabushiki Kaisha, Tokyo 100-8150 (JP); Origin Company, Limited, Saitama-shi Saitama 338-0823 (JP)
(72) Inventor: NODA, Naohiko, Komaki-shi, Aichi 485-8551 (JP); HAYASHI, Masahiro, Komaki-shi, Aichi 485-8551 (JP); NOMURA, Takatoshi, Komaki-shi, Aichi 485-8551 (JP); HAYASE, Shuzi, Chofu-shi, Tokyo 182-8585 (JP); NOMURA, Daishiro, Kitakyushu-shi, Fukuoka 804-0011 (JP); HIROTANI, Daisuke, Kitakyushu-shi, Fukuoka 804-0011 (JP); NAKAMURA, Masaki, Tokyo 100-8150 (JP); HIRAMI, Tomoyuki, Tokyo 100-8150 (JP); KUGA, Takayuki, Saitama-shi, Saitama 338-0823 (JP); KANI, Satoru, Saitama-shi, Saitama 338-0823 (JP); SASAHARA, Shinpei, Saitama-shi, Saitama 338-0823 (JP)
(74) Representative: Prüfer & Partner mbB Patentanwälte · Rechtsanwälte
(86) International application number: PCT/JP2022/036691
(87) International publication number: WO 2023/068015

(57) **Abstract**

A method of producing a tin-based perovskite layer includes: a first step for preparing a first solution (L3) by dissolving a tin-based perovskite compound in a solvent that does not contain dimethyl sulfoxide (DMSO); a third step for applying the first solution to a base (S) after the first step; and a second step for mixing DMSO (L2) with the first solution after the first step and a predetermined time before the third step.

## Description

### Cross-Reference to Related Application

The present application is based on Japanese Patent Application No. 2021-170558 filed on October 18, 2021, the entire contents of which are incorporated herein by reference.

### Technical Field

The present disclosure relates to a method of producing a tin-based perovskite layer used for solar cells.

### Background Art

Solar cells that include tin (Sn)-based perovskite layers that replace lead (Pb)-based perovskite layers for light-harvesting layers are proposed (see, e.g. PLT1). The solar cells that include the tin-based perovskite layers are considered to be environmentally friendly solar cells. In a tin-based perovskite material, divalent tin ions (Sn²⁺) are easily oxidized to tetravalent tin ions (Sn⁴⁺). The oxidization increases the hole density in the layer and decreases the photoelectric conversion efficiency of a solar cell. A method of producing a tin-based perovskite layer in PLT1 includes a step of adding a reducing agent to a solution that contains heavy tin halide to prepare a tin-based perovskite precursor solution. The reducing agent reduces tin fluoride in the tin-based perovskite precursor solution to tin and does not reduce the heavy tin halide in the tin-based perovskite precursor solution to tin. According to the method, Sn⁴⁺ is less likely to be mixed and the oxidation of Sn²⁺ is less likely to occur. Therefore, a significantly good solar cell can be provided.

### Citation List

### Patent Literature

PLT1: International Patent Application Laid-Open No. WO2020/175705

### Summary of Invention

### Technical Problem

The method described in PLT1 requires the preparation of the reducing agent, that is, an extra step. Further, the method requires determination of an optimal amount of the reducing agent to be added.

The present disclosure is for solving the above problem, and a main objective of the present disclosure is for providing a method of producing a tin-based perovskite layer in which preparation of a reducing agent is not required and oxidation of divalent tin ions (Sn²⁺) to tetravalent tin ions (Sn⁴⁺) is less likely to occur.

One aspect of the present disclosure provides a method of producing a thin-based perovskite layer including: a first step for preparing a first solution by dissolving a tin-based perovskite compound in a solvent that does not contain dimethyl sulfoxide (DMSO); a third step for applying the first solution to a base after the first step; and a second step for mixing DMSO with the first solution after the first step and a predetermined time before the third step.

According to the steps, in the first step, the first solution is prepared by dissolving the tin-based perovskite compound in the solvent that does not contain dimethyl sulfoxide (DMSO). In the third step, the first solution is applied to the base after the first step. The mixing of DMSO during the production of the tin-based perovskite layer is effective for promoting crystallization of the tin-based perovskite layer. However, the discloser of the present application focused on the fact that DMSO oxidizes divalent tin ions (Sn²⁺) to tetravalent tin ions (Sn⁴⁺) and reduces the photoelectric conversion efficiency of the tin-based perovskite layer.

In the second step, DMSO is mixed with the first solution after the first step and the predetermined time before the third step. In comparison to a first step in which DMSO is mixed, timing of the mixing of DMSO is delayed and thus the oxidation of Sn²⁺ to Sn⁴⁺ is less likely to occur. Further, the mixture of DMSO during the production of the tin-based perovskite layer promotes the crystallization of the tin-based perovskite layer.

In a second aspect, the predetermined time is less than 2 hours. In a third aspect, the predetermined time is less than 1 hour. In a fourth aspect, the predetermined time is less than 5 minutes. According to the steps, the timing of the mixing of DMSO is further delayed and thus the oxidation of Sn²⁺ to Sn⁴⁺ is further less likely to occur.

In a fifth aspect, DMSO is mixed with the first solution in the second step immediately before the third step. According to the step, the timing of the mixing of DMSO is the latest and thus the oxidation of Sn²⁺ to Sn⁴⁺ is further less likely to occur.

Specifically, as in a sixth aspect, the first solution is prepared in the first step by mixing the tin-based perovskite compound with the solution that does not contain DMSO and stirring mixture of the tin-based perovskite compound and the solvent to dissolve the tin-based perovskite compound in the solvent.

In a seventh aspect, the first solution is prepared in the first step by mixing the tin-based perovskite compound with the solvent that does not contain DMSO and stirring mixture of the tin-based perovskite compound and the solvent for 10 hours or more to dissolve the tin-based perovskite compound in the solvent. According to the step, the first solvent prepared by dissolving the perovskite compound in the solvent that does not contain DMSO is nearly homogeneous.

In an eighth aspect, the first solution is prepared in the first step by mixing the tin-based perovskite compound with the solvent that does not contain DMSO and stirring mixture of the tin-based perovskite compound and the solvent for 24 hours or more to dissolve the tin-based perovskite compound in the solvent. According to the step, the first solvent prepared by dissolving the perovskite compound in the solvent that does not contain DMSO is further nearly homogeneous.

In a ninth aspect, the first solution is stirred after DMSO is mixed with the first solution in the second step. According to the step, DMSO is less likely to be uneven in the first solution.

Specifically, as in a tenth aspect, the tin-based perovskite layer is represented by general formula ASnX₃, where A is at least one of an alkali metal ion, a rubidium ion, a methylammonium ion, an ethylammonium ion, a formamidium ion, a guanidium ion, and an alkylammonium ion, and X is at least one of Group VII elements including fluorine (F), chlorine (CL), bromine (Br), and iodine (I).

Specifically as in an eleventh aspect, for an iodine ion (I⁻), a fluorine ion (F⁻), a methylammonium ion (MA⁺), and dimethylformamide (DMF), the first solution contains SnI₂, SnF₂, and MAI as solutes and DMF as a solvent.

In a twelfth aspect, for formamidium ions (FA⁺), the first solution further contains FAI as a solute. According to the step, the quality of the tin-based perovskite layer can be further improved.

### Brief Description of Drawings

The above and other objects, features, and advantages of the present disclosure will be apparent from the following detailed description made with reference to the accompanying drawings.
[FIG. 1] A schematic view of a device for producing a tin-based perovskite layer.
[FIG. 2] A graph illustrating a relationship between stirring time and hole density in a comparative example that includes a solvent that contains only dimethyl sulfoxide (DMSO).
[FIG. 3] A graph illustrating relationships between output voltage and current density with stirring time of 1 hour and with stirring time of 24 hours in the comparative example.
[FIG. 4] A graph illustrating relationships between external quantum efficiency and short-circuit current density with respect to wavelength with stirring time of 1 hour and with stirring time of 24 hours in the comparative example.
[FIG. 5] A graph illustrating a relationship between stirring time and hole density in the comparative example that includes a solvent that contains dimethylformamide (DMF) and DMSO with a ratio of 4:1.
[FIG. 6] A schematic view of a modification of the device for producing a tin-based perovskite layer.
[FIG. 7] A schematic view of another modification of the device for producing a tin-based perovskite layer.

### Description of Embodiments

An embodiment including a device for producing a tin-based perovskite layer used in a tin-based perovskite solar cell will be described with reference to the drawings.

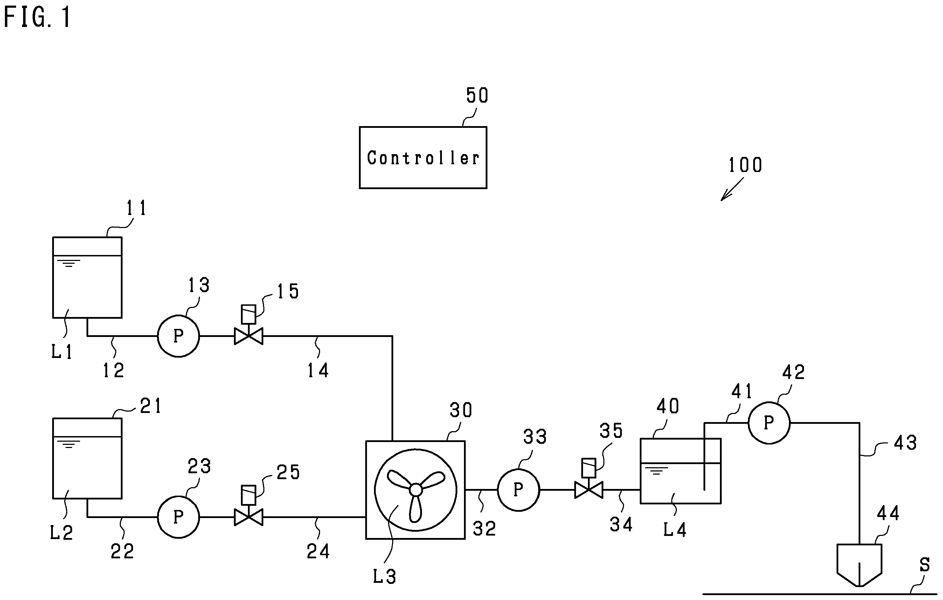

As illustrated in FIG. 1, a production device 100 includes a first container 11, a first pump 13, a first solenoid valve 15, a second container 21, a second pump 23, a second solenoid valve 25, a mixer 30, a third pump 33, a third solenoid valve 35, a buffer tank 40, a fourth pump 42, and an inkjet printer 44.

The first container 11 holds a first raw material liquid L1 (a first solution). The first raw material liquid L1 contains dimethylformamide (DMF), stannous iodide (SnI₂), stannous fluoride (SnF₂), and methylammonium iodide (MAI) for DMF, tin ions (Sn²⁺), iodine ions (I⁻), fluorine ions (F⁻), and methylammonium ions (MA⁺), and does not contain dimethyl sulfoxide (DMSO). The first raw material liquid L1 is stirred for 24 hours (10 hours or more, 24 hours or more) before being stored in the first container 11.

SnI₂, SnF₂, and MAI are raw materials of a tin-based perovskite compound. A material represented by general formula ASnX₃ may be used for the tin-based perovskite compound. The first row material liquid L1 may use raw materials represented by general formula AX and general formula SnX₂ for the perovskite compound. Here, A may be at least one of an alkali metal ion, a rubidium ion, a methylammonium ion, an ethylammonium ion, a formamidium ion, a guanidium ion, and an alkylammonium ion. X may be at least one of Group VII elements including fluorine (F), chlorine (CL), bromine (Br), and iodine (I).

In the first raw material liquid L1, a molar ratio of AX and SnX₂ is adjusted based on the target characteristics of the perovskite layer. When forming a perovskite compound for a light absorber, a preferably molar ratio of AX and SnX₂ may be 1:10 to 10:1.

DMF may be a solvent that does not contain DMSO. The solvent that does not contain DMSO is not limited as long as it can dissolve AX and SnX₂ described above; however, a polar solvent may be preferable. Specifically, γ-butyrolactone, N-methyl-2-pyrrolidone, N,N-dimethylformamide, isopropanol, sulfolane, propylene carbonate, ethylcyanoacetate, acetyl acetone, cyclopentanone, cyclohexanone, cycloheptane, aniline, piperidine, pyridine, cyclooctanone, tetrahydrofurfuryl acetate, cyclohexyl acetate, cyclopentyl methyl ether, phenylethylamine, ethlenediamine, trimethylamine, diisopropylethylamine, or hydrazine may be used.

The first pump 13 is connected to the first container 11 via a flow channel 12. The mixer 30 is connected to the first pump 13 via a flow channel 14. The first solenoid valve 15 is disposed in the flow channel 14. The first pump 13 sucks the first raw material liquid L1 from the first container 11 and discharges the first raw material liquid L1 to the first solenoid valve 15. The first solenoid valve 15 allows and blocks a supply of the first raw material liquid L1, which is discharged by the first pump 13, to the mixer 30. The first pump 13 and the first solenoid valve 15 are controlled by a controller 50.

The second container 21 holds a second raw material liquid L2. The second raw material liquid L2 contains DMSO. The second pump 23 is connected to the second container 21 via a flow channel 22. The mixer 30 is connected to the second pump 23 via a flow channel 24. The second solenoid valve 25 is disposed in the flow channel 24. The second pump 23 sucks the second raw material liquid L2 from the second container 21 and discharges the second raw material liquid L2 to the second solenoid valve 25. The second solenoid valve 25 allows and blocks a supply of the second raw material liquid L2, which is discharged by the second pump 23, to the mixer 30. The second pump 23 and the second solenoid valve 25 are controlled by the controller 50.

The mixer 30 holds the first raw material liquid L1 supplied via the first solenoid valve 15 and the second raw material liquid L2 supplied via the second solenoid valve 25. The mixer 30 stirs the first raw material liquid L1 and the second raw material liquid L2 in the mixer 30. Namely, the mixer 30 functions as a tank for storing the first raw material liquid L1 and the second raw material liquid L2. Further, the mixer 30 functions as a stirrer for stirring the first raw material liquid L1 and the second raw material liquid L2 in the mixer 30. Through the stirring of the first raw material liquid L1 and the second raw material liquid L2 by the mixer 30, a precursor solution L3 (a solution) in which a tin-based perovskite compound is dissolved in a solvent is prepared. The mixer 30 is controlled by the controller 50.

The third pump 33 is connected to the mixer 30 via a flow channel 32. The buffer tank 40 is connected to the third pump 33 via a flow channel 34. The third solenoid valve 35 is disposed in the flow channel 34. The third pump 33 sucks the precursor solution L3 from the mixer 30 and discharges the precursor solution L3 to the third solenoid valve 35. The third solenoid valve 35 allows and blocks a supply of the precursor solution L3 discharged by the third pump 33 to the buffer tank 40. The third pump 33 and the third solenoid valve 35 are controlled by the controller 50.

The buffer tank 40 holds the precursor solution L3 supplied from the mixer 30 via the third solenoid valve 35. The buffer tank 40 has a holding capacity that is sufficient for stably supplying the precursor solution L4 to the inkjet printer 44 that continuously discharges the precursor solution L4 for a certain period of time.

The fourth pump 42 is connected to the buffer tank 40 via a flow channel 41. The inkjet printer 44 is connected to the fourth pump 42 via a flow channel 43. The fourth pump 42 sucks the precursor solution L4 from the buffer tank 40 and discharges the precursor solution L4 to the inkjet printer 44. The fourth pump 42 is controlled by the controller 50.

The inkjet printer 44 (a discharger) discharges the precursor solution L4 supplied from the buffer tank 40 onto a base S. Namely, the inkjet printer 44 applies the precursor solution L4 to the base S. The inkjet printer 44 is controlled by the controller 50. The base S includes a substrate (e.g., a glass substrate, a flexible substrate) on which a transparent conductive layer and an electron transport layer or a hole transport layer are formed in this sequence from the substrate side. The inkjet printer 44 may be replaced with a slot die, a spin coater, or a roll coater.

Chlorobenzene, which is a poor solvent, is dropped onto the precursor solution L4 on the base S and then the precursor solution L4 is heated and dried (an annealing step, a heating step) to form the perovskite layer. The heating temperature may be 20 °C to 300 °C, preferably 50 °C to 170 °C. When the precursor solution L4 is heated, a three-dimensional crystal structure (a perovskite structure) begins to form. In this embodiment, the three-dimensional structure crystal is MASnI₃ (CH₃NH₃SnI₃).

The thickness of the perovskite layer is preferably 10 to 5000 [nm], more preferably 100 to 1000 [nm], so that the photoelectric conversion efficiency is more likely to improve even in low temperature (200 °C or less) processing. A hole transport layer or an electron transport layer and an electrode are layered on the perovskite layer.

The control unit 50 includes at least a CPU, a ROM, a RAM, and an input/output interface. The control unit 50 controls the first pump 13, the first solenoid valve 15, the second pump 23, the second solenoid valve 25, the mixer 30, the third pump 33, the third solenoid valve 35, the fourth pump 42, and the inkjet printer 44.

Next, a method of producing the tin-based perovskite layer will be described.

The first raw material liquid L1 is stirred for 24 hours (10 hours or more, 24 hours or more) by a stirrer, which is not illustrated (a first step). The stirrer may be controlled by the controller 50 or by another controller, or manually operated by an operator. Then, the first raw material liquid L1 that is stirred is supplied to the first container 11.

The controller 50 controls the first pump 13 to discharge the first raw material liquid L1 to the first solenoid valve 15 and controls the first solenoid valve 15 to supply the first raw material liquid L1 to the mixer 30.

The controller 50 controls the second pump 23 to discharge the second raw material liquid L2 to the second solenoid valve 25 and then controls the second solenoid valve 25 to supply the second raw material liquid L2 to the mixer 30. Namely, after the first raw material liquid L1 that is stirred in advance is supplied to the mixer 30 via the first solenoid valve 15, the second raw material liquid L2 is supplied to the mixer 30 via the second solenoid valve 25 (a second step).

The controller 50 controls the mixer 30 to stir the first raw material liquid L1 and the second raw material liquid L2 in the mixer 30 for one minute (or quickly stir them). Through the steps, the precursor solution L3 is prepared.

The controller 50 controls the third pump 33 to discharge the precursor solution L3 to the third solenoid valve 35 and then controls the third solenoid valve 35 to supply the precursor solution L3 to the buffer tank 40. Namely, the controller 50 controls the third solenoid valve 35 to supply the precursor solution L3 to the buffer tank 40 after the first raw material liquid L1 and the second raw material liquid L2 in the mixer 30 are stirred.

The controller 50 controls the fourth pump 42 to discharge the precursor solution L4 in the buffer tank 40 to the inkjet printer 44.

The controller 50 controls the inkjet printer 44 to discharge the precursor solution L4 supplied from the buffer tank 40 onto the base S (a third step). After the first raw material liquid L1 is stirred and a predetermined period of time before the precursor solution L4 supplied from the buffer tank 40 is discharged to the base S via the inkjet printer 44, the controller 50 controls the second solenoid valve 25 to supply the second raw material liquid L2 to the mixer 30. The predetermined period of time may be less than 2 hours, preferably less than 1 hour, and more preferably less than 5 minutes.

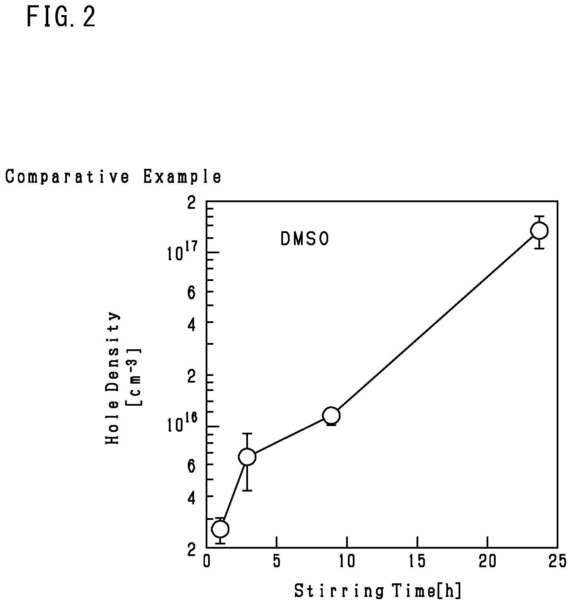

A graph in FIG. 2 illustrates a relationship between stirring time and hole density in a comparative example that includes a solvent that contains only DMSO.

The solvent that dissolve the tin-based perovskite compound is prepared from only DMSO and used to produce the tin-based perovskite layer. In such a tin-based perovskite layer, the hole density increases as a period of time in which the raw material liquid that consists of DMSO, SnI₂, and MAI is stirred increases. This is because the DMSO oxidizes divalent tin ions (Sn²⁺) to tetravalent tin ions (Sn⁴⁺). As the hole density of the tin-based perovskite layer increases, the photoelectric conversion efficiency of the tin-based perovskite layer decreases.

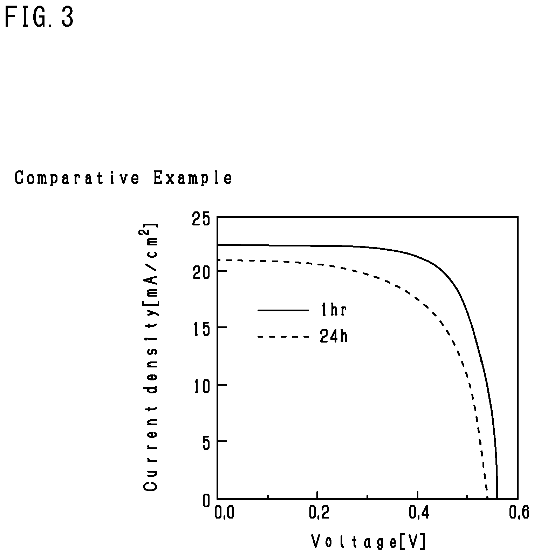

A graph in FIG. 3 illustrates relationships between output voltage [V] and current density [mA/cm²] with stirring time of 1 hour and with stirring time of 24 hours in the comparative example. With the stirring time of 24 hours, the current density is low in comparison to the current density with the stirring time of 1 hour.

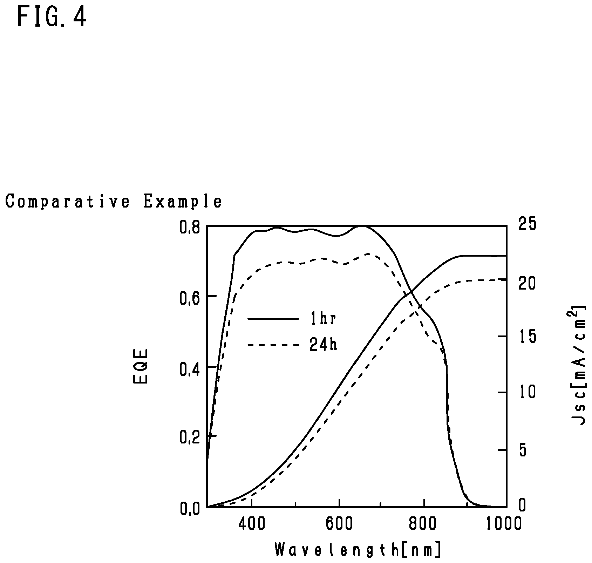

A graph in FIG. 4 illustrates relationships between external quantum efficiency (EQE) and short-circuit current density (Jsc) with respect to wavelength with stirring time of 1 hour and with stirring time of 24 hours in the comparative example. With the stirring time of 24 hours, the external quantum efficiency (EQE) and the short-circuit current density (Jsc) are low in comparison to those with the stirring time of 1 hour.

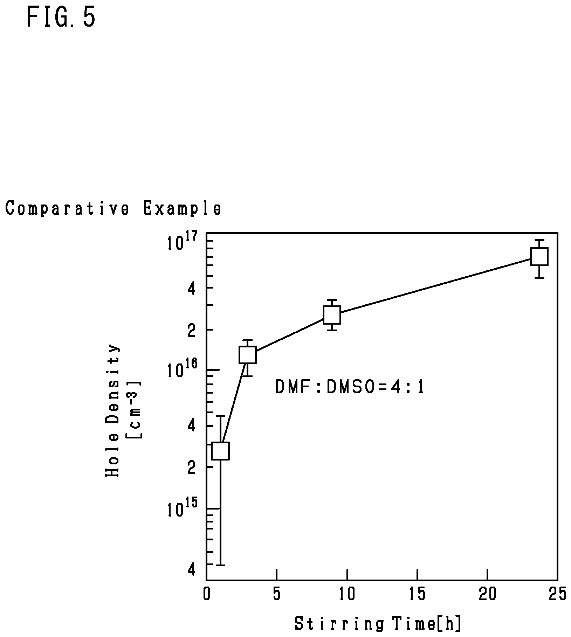

A graph in FIG. 5 illustrates a relationship between stirring time and hole density in the comparative example that uses a solvent that contains DMF and DMSO with a ratio of 4:1.

The hole density of the tin-based perovskite layer produced using the solvent that contains DMF and DMSO with the ratio of 4:1 for dissolving the tin-based perovskite compound increases as the stirring time of the raw material liquid that contains DMF, DMSO, SnI₂, SnF₂, and MAI increases. In the comparative example, DMSO also oxidizes divalent tin ions (Sn²⁺) to tetravalent tin ions (Sn⁴⁺).

The mixing of DMSO during the production of the tin-based perovskite layer is effective for promoting crystallization of the tin-based perovskite layer. To suppress the oxidation of Sn²⁺ to Sn⁴⁺, in the method of producing the tin-based perovskite layer described above, the first raw material liquid L1 that has been stirred in advance is supplied to the mixer 30 via the first solenoid valve 15 and then the second raw material liquid L2 is supplied to the mixer 30 via the second solenoid valve 25. Further, after the first raw material liquid L1 is stirred and the predetermined period of time before the precursor solution L4 supplied from the buffer tank 40 is discharged to the base S via the inkjet printer 44, the controller 50 controls the second solenoid valve 25 to supply the second raw material liquid L2 to the mixer 30.

The photoelectric conversion efficiency of the tin-based perovskite layer in the comparative example produced by simultaneously supplying the first raw material liquid L1 and the second raw material liquid L2 to the mixer 30 and then stirring them by the mixer 30 for 24 hours was 2.9%. The photoelectric conversion efficiency of the tin-based perovskite layer in this embodiment produced by supplying the first raw material liquid L1 that has been stirred for 24 hours in advance to the mixer 30, then supplying the second raw material liquid L2 to the mixer 30, and stirring them for one minute (or quickly stirring them) was 6.4%. By reducing the time from when DMSO is added after the first raw material liquid L1 is stirred to when the precursor solution L4 is discharged by the inkjet printer 44, the oxidation of Sn²⁺ to Sn⁴⁺ is less likely to occur.

The embodiment described in detail above has the following advantages.

In the second step, DMSO is mixed with the precursor solution L3 after the first step and the predetermined time before the third step. Specifically, after the first raw material liquid L1 that has been stirred in advance is supplied to the mixer 30 via the first solenoid valve 15 and the predetermined time before the precursor solution L4 that is supplied from the buffer tank 40 is discharged onto the base S via the inkjet printer 44, the controller 50 controls the second solenoid valve 25 to supply the second raw material liquid L2 to the mixer 30. In comparison to the method in which the DMSO is mixed in the first step, the timing of the mixing of DMSO is delayed and thus the oxidation of Sn²⁺ to Sn⁴⁺ by DMSO is less likely to occur. According to the method, the oxidation of Sn²⁺ to Sn⁴⁺ can be suppressed without an additional reducing agent. Further, DMSO is mixed during the production of the tin-based perovskite layer. This promotes the crystallization of the tin-based perovskite layer.

The predetermined time is less than 2 hours. The predetermine time is preferably less than 1 hour and more preferably less than 5 minutes. According to the steps, the timing of the mixing of DMSO is delayed, and thus the oxidation of Sn²⁺ to Sn⁴⁺ is less likely to occur.

In the first step, the first raw material liquid L1 is prepared by mixing the tin-based perovskite compound with the solvent that does not contain DMSO and dissolving the perovskite compound by stirring for 24 hours (10 hours or more, 24 hours or more). The first raw material liquid L1 prepared by dissolving the perovskite compound in the solvent that does not contain DMSO through this step is nearly homogeneous.

In the second step, the first raw material liquid L1 is stirred after DMSO is mixed with the first raw material liquid L1. Specifically, after the second raw material liquid L2 is supplied to the mixer 30 via the second solenoid valve 25 and the first raw material liquid L1 and the second raw material li1uid L2 are stirred by the mixer 30, the controller 50 controls the third solenoid valve 35 to supply the precursor solution L3 to the buffer tank 40. According to the step, DMSO is less likely to be uneven in the precursor solution L3.

The first solenoid valve 15 allows and blocks the supply of the first raw material liquid L1 prepared by mixing the tin-based perovskite compound with the solvent that does not contain DMSO. The supply of the first raw material liquid L1 that has been stirred in advance can be allowed by the first solenoid valve 15.

The second solenoid valve 25 allows and blocks the supply of DMSO, that is, the second raw material liquid L2. The mixer 30 holds the first raw material liquid L1 supplied via the first solenoid valve 15 and the second raw material liquid L2 supplied via the second solenoid valve 25 and stirs them. The controller 50 controls the first solenoid valve 15, the second solenoid valve 25, and the mixer 30. Through the control of the first solenoid valve 15 and the second solenoid valve 25 by the controller 50, the first raw material liquid L1 and the second raw material liquid L2 are supplied to the mixer 30. Further, through the control of the mixer 30 by the controller 50, the first raw material liquid L1 and the second raw material liquid L2 in the mixer 30 are stirred.

Through the control of the first solenoid valve 15 and the second solenoid valve 25 by the controller 50, the timing of the supply of the first raw material liquid L1 to the mixer 30 and the timing of the supply of the second raw material liquid L2 to the mixer 30 can be controlled. The timing of the supply of the second raw material liquid L2 to the mixer 30 can be delayed relative to the timing of the supply of the first raw material liquid L1 to the mixer 30. The controller 50 then controls the mixer 30 to stir the first raw material liquid L1 and the second raw material liquid L2 in the mixer 30. Therefore, the oxidation of Sn²⁺ to Sn⁴⁺ can be suppressed without an additional reducing agent. Further, the mixing of DMSO during the production of the tin-based perovskite layer promotes the crystallization of the tin-based perovskite layer. The precursor solution L3 supplied from the mixer 30 can be supplied to the buffer tank 40 via the third solenoid valve 35.

The buffer tank 40 holds the precursor solution L3 supplied from the mixer 30 via the third solenoid valve 35. The precursor solution L3 can be temporarily stored in the buffer tank 40 and thus precursor solution L3 can be stably supplied to the inkjet printer 44. Further, the controller 50 can control the inkjet printer 44 to discharge the precursor solution L4 supplied from the buffer tank 40 to the base S.

The controller 50 controls the second pump 23 to discharge the second raw material liquid L2 to the second solenoid valve 25 and then control the second solenoid valve 25 to supply the second raw material liquid L2 to the mixer 30 after the control of the first pump 13 to discharge the first raw material liquid L1 to the first solenoid valve 15 and the control of the first solenoid valve 15 to supply the first raw material liquid L1 to the mixer 30. According to the configuration, the timing of the supply of the second raw material liquid L2 to the mixer 30 can be delayed relative to the timing of the supply of the first raw material liquid L1 to the mixer 30.

The second raw material liquid L2 can be supplied to the mixer 30 after the first raw material liquid L1 that has been stirred in advance is supplied to the mixer 30. Therefore, a second raw material (i.e., DMSO) can be added after the tin-based perovskite compound is dissolved in the solvent that does not contain DMSO in advance. Therefore, the oxidation of Sn²⁺ to Sn⁴⁺ is further less likely to occur.

The precursor solution L3 can be supplied to the third solenoid 35 after the first raw material liquid L1 and the second raw material liquid L2 in the mixer 30 are stirred. Therefore, the tin-based perovskite compound can be more easily dissolved in DMSO that is added later.

The embodiment described above may be modified and implemented as follows. Components that are the same as those in the embodiment described above may be denoted by the reference signs of the corresponding components and will not be described.

For formamidium ions (FA⁺), formamidium iodide (FAI) may be contained in the first raw material liquid L1 (or the precursor solution L3) as a solute. The photoelectric conversion efficiency of the tin-based perovskite layer of the comparative example that was produced by simultaneously supplying the first raw material liquid L1 and the second raw material liquid L2 to the mixer 30 and stirring them by the mixer 30 for 24 hours was 4.6%. The photoelectric conversion efficiency of the tin-based perovskite layer of the embodiment produced by supplying the first raw material liquid L1 that has been stirred for 24 hours to the mixer 30 and then supplying the second raw material liquid L2 to the mixer 30 and stirring them for one minute (or quickly stir them) was 9.5%. By reducing the time from when DMSO is added after the first raw material liquid L1 that contains FAI is stirred to when the precursor solution L4 is discharged via the inkjet printer 44, the oxidation of Sn²⁺ to Sn⁴⁺ is less likely to occur.

In the second step, DMSO may be mixed with the precursor solution L3 immediately before the third step. According to the method, the timing of the mixing of DMSO can be delayed and thus the oxidation of Sn²⁺ to Sn⁴⁺ by DMSO is further less likely to occur.

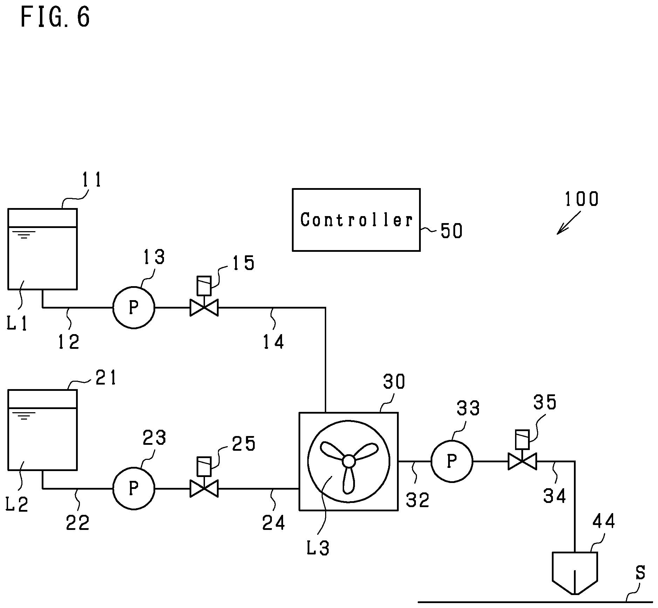

The buffer tank 40 and the fourth pump 42 may be removed from the tin-based perovskite layer production device 100 as illustrated in FIG. 6. In this configuration, the holding capacity of the mixer 30 may be set equal to or greater than the holding capacity of the buffer tank 40.

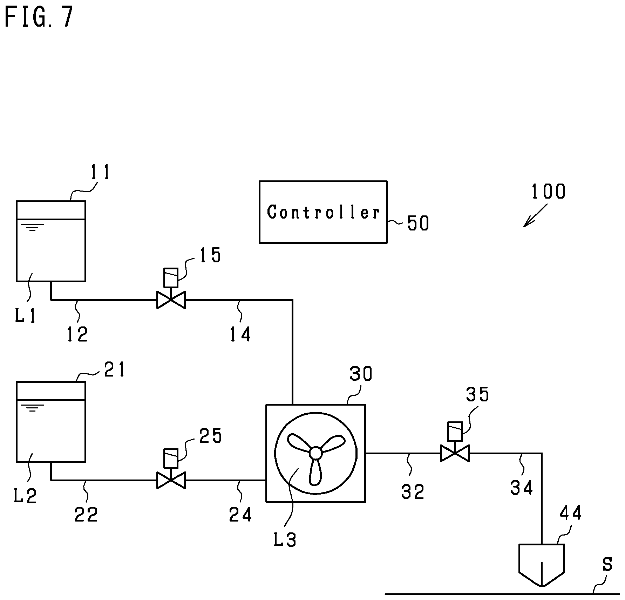

The first pump 13, the second pump 23, and the third pump 33 may be removed from the tin-based perovskite layer production device 100 in FIG. 6 as illustrated in FIG. 7. In this configuration, the first raw material liquid L1 in the first container 11, the second raw material liquid L2 in the second container 21, and the precursor solution L3 in the mixer 30 may be supplied using their potential energies.

The modifications described above may be combined and implemented.

The present disclosure has been described in conformity with examples but is not limited to the examples and the structures therein. Further, the present disclosure encompasses a variety of variation examples and variations in the scope of equivalents of the present disclosure. In addition, a variety of combinations and forms and even other combinations and forms to which only one element or two or more elements are added fall within the scope and ideological range of the present disclosure.

### Reference Sings List

11: First container, 21: Second container, 30: Mixer, 40: Buffer tank, 44: Inkjet printer (Discharger), 50: Controller, 100: Production device

## Claims

1. A method of producing a tin-based perovskite layer, the method comprising:
a first step for preparing a first solution by dissolving a tin-based perovskite compound in a solvent that does not contain dimethyl sulfoxide (DMSO);
a third step for applying the first solution to a base after the first step; and
a second step for mixing DMSO with the first solution after the first step and a predetermined time before the third step.

2. The method according to claim 1, wherein the predetermined time is less than 2 hours.

3. The method according to claim 1 or 2, wherein the predetermined time is less than 1 hour.

4. The method according to any one of claims 1 to 3, wherein the predetermined time is less than 5 minutes.

5. The method according to any one of claims 1 to 4, wherein DMSO is mixed with the first solution in the second step immediately before the third step.

6. The method according to any one of claims 1 to 5, wherein the first solution is prepare in the first step by mixing the tin-based perovskite compound with the solvent that does not contain DMSO and stirring mixture of the tin-based perovskite compound and the solvent to dissolve the tin-based perovskite compound in the solvent.

7. The method according to any one of claims 1 to 6, wherein the first solution is prepared in the first step by mixing the tin-based perovskite compound with the solvent that does not contain DMSO and stirring mixture of the tin-based perovskite compound and the solvent for 10 hours or more to dissolve the tin-based perovskite compound in the solvent.

8. The method according to any one of claims 1 to 7, wherein the first solution is prepared in the first step by mixing the tin-based perovskite compound with the solvent that does not contain DMSO and stirring mixture of the tin-based perovskite compound and the solvent for 24 hours or more to dissolve the tin-based perovskite compound in the solvent.

9. The method according to any one of claims 6 to 8, wherein the first solution is stirred after DMSO is mixed with the first solution in the second step.

10. The method according to any one of claims 1 to 9, wherein
the tin-based perovskite layer is represented by general formula ASnX₃,
A is at least one of an alkali metal ion, a rubidium ion, a methylammonium ion, an ethylammonium ion, a formamidium ion, a guanidium ion, and an alkylammonium ion, and
X is at least one of Group VII elements including fluorine (F), chlorine (CL), bromine (Br), and iodine (I).

11. The method according to any one of claims 1 to 10, wherein for an iodine ion (I⁻), a fluorine ion (F⁻), a methylammonium ion (MA⁺), and dimethylformamide (DMF), the first solution contains SnI₂, SnF₂, and MAI as solutes and DMF as a solvent.

12. The method according to claim 11, wherein for formamidium ions (FA⁺), the first solution further contains FAI as a solute.
